# EUROPEAN PATENT APPLICATION

(11) **EP 1 768 479 A2**
(43) Date of publication of application: **28.03.2007**
(21) Application number: 06253956.4
(22) Date of filing: 28.07.2006
(51) Int. Cl.: H05K 7/20, G06F 1/16

(54) **Display device**

(30) Priority: 22.09.2005 JP 2005275409
(71) Applicant: ORION ELECTRIC CO., Ltd., Fukui 915-8555 (JP)
(72) Inventor: Uchizono, Tatsuya, c/o Orion Electric Co. Ltd., Echizen-city, Fukui 915-8555 (JP); Tajima, Koichi, c/o Orion Electric Co. Ltd., Echizen-city, Fukui 915-8555 (JP); Mukougawa, Hidenobu, c/o Orion Electric Co. Ltd., Echizen-city, Fukui 915-8555 (JP)
(74) Representative: Paget, Hugh Charles Edward

(57) **Abstract**

The invention provides a display device designed to reliably discharge air heated to a high temperature to the outside. Heat from a heating part mounted on a power supply substrate 21 is transmitted to air inside an enclosure 2 and the air heated to a high temperature moves upward by means of natural convection and is discharged through exhaust holes 12 in the upper surface of a back cabinet 4. As a result of this, outside air is taken in through intake holes 10 in the lower surface of the back cabinet 4, the outside air pushes up the air inside the enclosure 2 from below and discharges it, and it is possible to thereby prevent the air inside the enclosure 2 from becoming hot and forcibly take in/exhaust air, eliminate the necessity for any air blowing fan and thereby achieve cost reduction.

## Description

### BACKGROUND OF THE INVENTION

### Field of the Invention

The present invention relates to a display device incorporating a heating part which generates high-temperature heat, or more specifically, to a display device provided with a heat radiation structure which discharges high-temperature heat generated inside an enclosure by the heating part to the outside.

### Description of the Related Art

A conventional display device is generally characterized by a large-screen display panel for displaying video and a low-profile overall shape having a small depth. Examples of typical products of such a low-profile display device include a liquid crystal television and plasma display device or the like and while these products have the aforementioned feature of allowing space-saving installation, a plurality of electronic parts including the display panel need to be accommodated within a limited space inside an enclosure. Furthermore, it is considered as one of the problems how to efficiently discharge heat generated from the electronic part disposed inside the enclosure out of the enclosure. A display device such as a plasma display device provided with a large-screen display panel in particular has a problem that a large amount of heat is generated from a power supply substrate to operate the display panel. More specifically, such a display device is provided with a heat radiation member to discharge heat from the heating part mounted on the power supply substrate and high-temperature heat generated from the heating part is radiated through this heat radiation member, but the radiated heat is accumulated inside the enclosure if left uncontrolled, and therefore some means for discharging the heat out of the enclosure is required. In a general display device, as shown in, for example, Japanese Patent Laid-Open Publications No. 10-117315, No. 10-171360, No. 10-233979, No. 11-153959 and No. 11-284379 (Patent Documents 1 to 5), a structure for forcibly discharging air heated to a high temperature inside an enclosure using an air blowing fan to effectively discharge heat generated inside the enclosure is disclosed. Furthermore, as disclosed in, for example, Patent Document 1, the general display device is provided with a display panel disposed on the front side of the enclosure, and therefore when the air blowing fan is provided inside the enclosure, the fan is attached to the inner surface of the back of the enclosure in most cases for design-related reasons.

Furthermore, to discharge heat generated from a display panel out of an enclosure, Japanese Patent Laid-Open Publication No. 9-261557 (Patent Document 6) discloses a structure whereby a plurality of holes are formed in the front of the enclosure which is the periphery of the display plane on which television video is displayed and heat generated from the display panel is radiated through these holes.

However, when an air blowing fan for heat radiation is provided inside the enclosure as described in Patent Documents 1 to 5, the air blowing fan and a work process of assembling the air blowing fan are required, which results in an increase in the number of parts and leads to an increase of manufacturing cost, making it impossible to suppress cost to a low level. Moreover, according to the structure described in Patent Document 1 whereby the air blowing fan is provided on the inner surface of the back of the enclosure and air is discharged through exhaust holes formed in the back, when the display device is hung on the wall, the exhaust holes contact the wall and are thereby blocked, which is not desirable. Moreover, according to Patent Document 6, holes are formed horizontally in the enclosure, and therefore when heated air moves upward as the temperature increases, the air cannot be smoothly let out unless the air is forcibly exhausted using an air blowing fan because holes are formed in the horizontal direction which is different from the direction in which the air moves.

### SUMMARY OF THE INVENTION

The present invention has been implemented in view of the above described problems and it is an object of the present invention to provide a display device having a heat radiation structure designed to reliably discharge air heated to a high temperature inside an enclosure and reduce the number of parts and thereby achieve cost reduction.

The display device according to aspect 1 is a display device with a display panel for displaying images accommodated in an enclosure, comprising a heating part which is heated inside the enclosure during operation of the display panel, a plurality of exhaust holes for discharging air heated to a high temperature inside the enclosure formed in the top surface of the enclosure and a plurality of air intake holes for taking in outside air formed in the bottom surface of the enclosure.

According to the construction of aspect 1, when the air inside the enclosure becomes hot with heat generated from the heating part disposed inside the enclosure while the display device is operating, that is, while images are being displayed on the display panel, the air heated to a high temperature moves upward by means of natural convection, is discharged through the exhaust holes provided in the top surface of the enclosure, and as a result, outside air flows into the enclosure through the air intake holes and the outside air introduced into the enclosure through the air intake holes pushes up the heated air inside the enclosure from below, and therefore the high-temperature air is smoothly discharged through the exhaust holes without being confined in the enclosure.

The display device according to aspect 2 is a display device provided with a display panel for displaying images fitted in a front cabinet and a back cabinet combined with the front cabinet in an integrated manner, comprising a heating part which generates high-temperature heat during operation of the display panel provided inside an enclosure made up of the front cabinet and back cabinet, a plurality of exhaust holes for exhausting air heated to a high temperature inside the enclosure formed in a top surface of the back cabinet and a plurality of air intake holes through which outside air is taken in formed in a bottom surface of the back cabinet.

According to the construction of aspect 2, the display panel of the display device is attached to the front cabinet which serves as the front side of the enclosure, the plurality of exhaust holes are provided in the top surface of the back cabinet which serves as the back side of the enclosure, the plurality of air intake holes are provided in the bottom surface of the back cabinet and the back cabinet is attached to the front cabinet, and therefore when the display panel is in operation, the high-temperature air generated from the heating part attached inside the enclosure is discharged through the exhaust holes and at the same time the outside air is taken in through the air intake holes, which in turn pushes up the heated air inside the enclosure from below, and therefore the high-temperature air is smoothly discharged through the exhaust holes without being confined in the enclosure.

The display device according to aspect 3 is the display device according to aspect 1 or 2, further comprising a shielding plate provided in an upper part inside the enclosure for guiding the air heated to a high temperature to the exhaust holes.

According to the construction of aspect 3, when the high-temperature air inside the enclosure moves upward and the air ascending by means of natural convection contacts the shielding plate, this air moves along the surface of the shielding plate and is discharged through the exhaust holes, and therefore it is possible to prevent the high-temperature air from flowing into gaps in the upper part of the enclosure and being accumulated there.

The display device according to aspect 4 is the display device according to any one of aspects 1 to 3, wherein the heating part is mounted on a power supply substrate to operate the display panel and the power supply substrate is provided with a heat radiation member for radiating heat of the heating part.

According to the construction of aspect 4, the heating part mounted on the power supply substrate generates heat while the display panel is operating, the heat from the heating part is radiated out of the enclosure through the heat radiation member provided for the power supply substrate, this radiated high-temperature air is discharged outward through the exhaust holes provided in the top surface of the enclosure and at the same time the outside air is taken in through the air intake holes, which in turn pushes up the heated air inside the enclosure from below, and therefore the high-temperature air generated from the heating part provided for the power supply substrate is smoothly discharged through the exhaust holes without being confined in the enclosure.

The display device according to aspect 5 is the display device according to aspect 4, wherein the power supply substrate is disposed on a back side of the display panel between the plurality of air intake holes for taking in outside air and the plurality of exhaust holes for discharging air heated to a high temperature inside the enclosure, both holes being provided in the enclosure.

According to the construction of aspect 5, the power supply substrate mounted with the heating part is disposed between the air intake holes and exhaust holes through which air is taken in/exhausted, and therefore it is possible to efficiently discharge the high-temperature air generated inside the enclosure out of the enclosure.

### BRIEF DESCRIPTION OF THE DRAWINGS

FIG. 1 is a perspective view of a display device showing an example of the present invention viewed from the back;
FIG. 2 is a perspective view of the display device showing the example of the present invention rid of a stand viewed from the back;
FIG. 3 is a sectional view of the display device showing the example of the present invention viewed from one side; and
FIG. 4 is a perspective view of the display device showing the example of the present invention rid of the back cabinet viewed from the back.

### DETAILED DESCRIPTION OF THE PREFERRED EMBODIMENTS

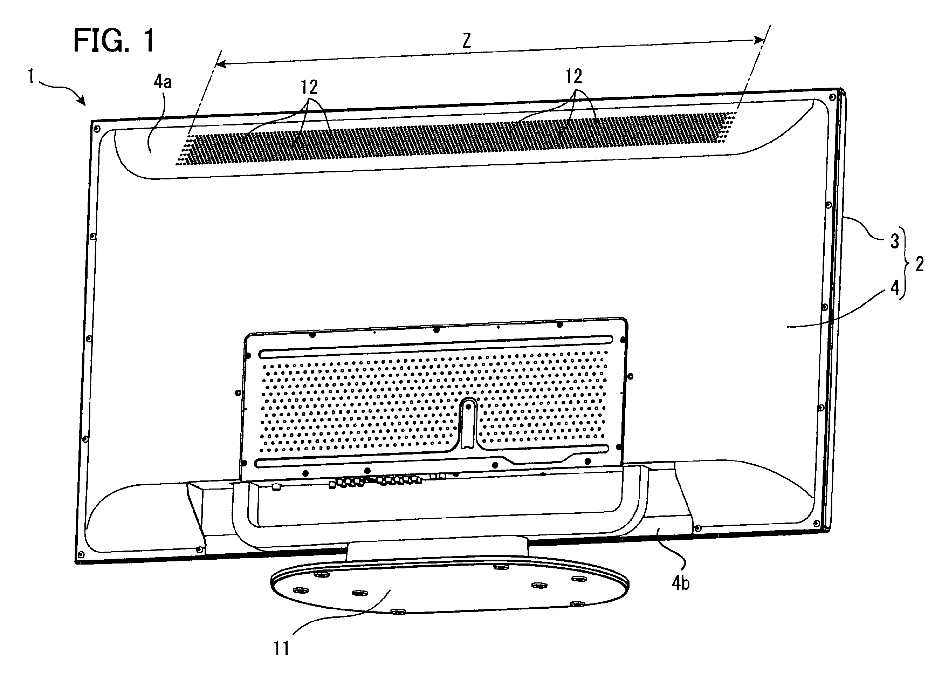

Hereinafter, embodiments as the best modes of implementing the present invention will be explained with reference to FIGS. 1 to 4. It goes without saying that the present invention is also easily applicable to cases other than those explained in the embodiments within a range without departing from the essence of the present invention.

FIG. 1 is a perspective view of a display device viewed from the back showing an example of the present invention. A resin enclosure 2 of a display device 1 is composed of a front cabinet 3 and back cabinet 4 which are coupled into one box-shaped body, characterized by its small depth dimension and a plurality of air intake holes 10 are formed in a lower part of the back cabinet 4 to take in outside air into the enclosure 2 and a support stand 11 is attached to the bottom of the display device 1 in an integrated manner to keep the enclosure 2 in a predetermined position. A display panel for displaying images is attached to the front of the front cabinet 3, which will be described later.

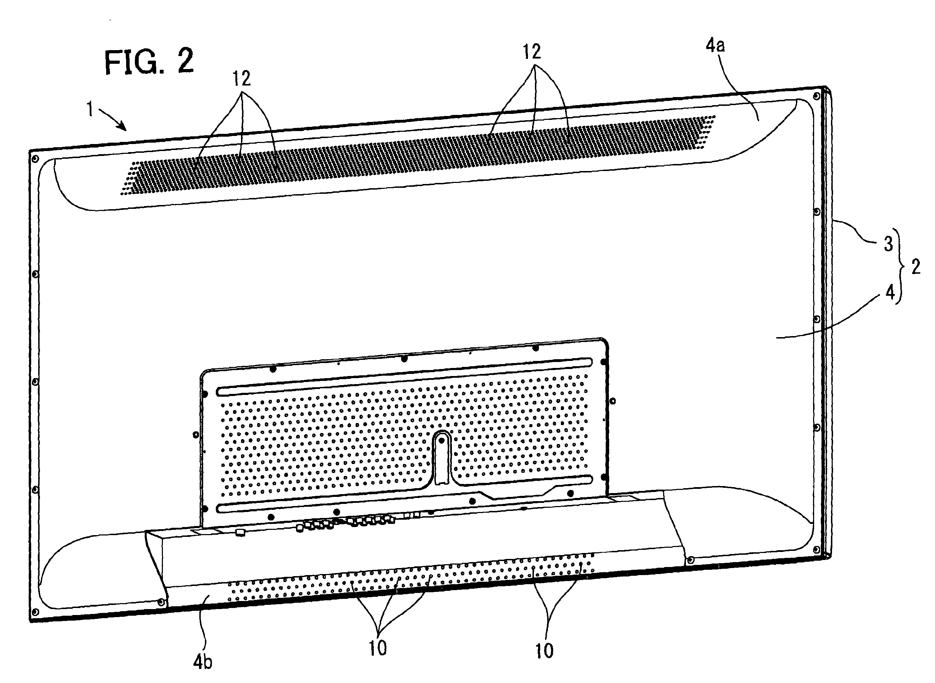

FIG. 2 is a perspective view showing the display device rid of the stand viewed from the back. As shown in the same figure, a plurality of exhaust holes 12 for exhausting the air inside the enclosure 2 are formed in a slope 4a which constitutes the upper part of the back cabinet 4 and a plurality of air intake holes 10 for taking in outside air are formed in a slope 4b which constitutes the lower part thereof.

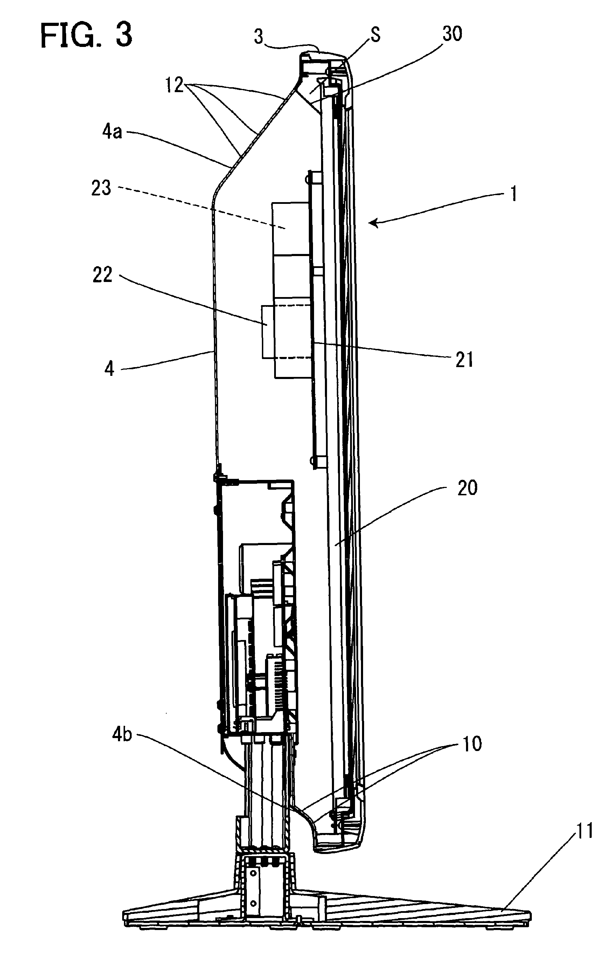

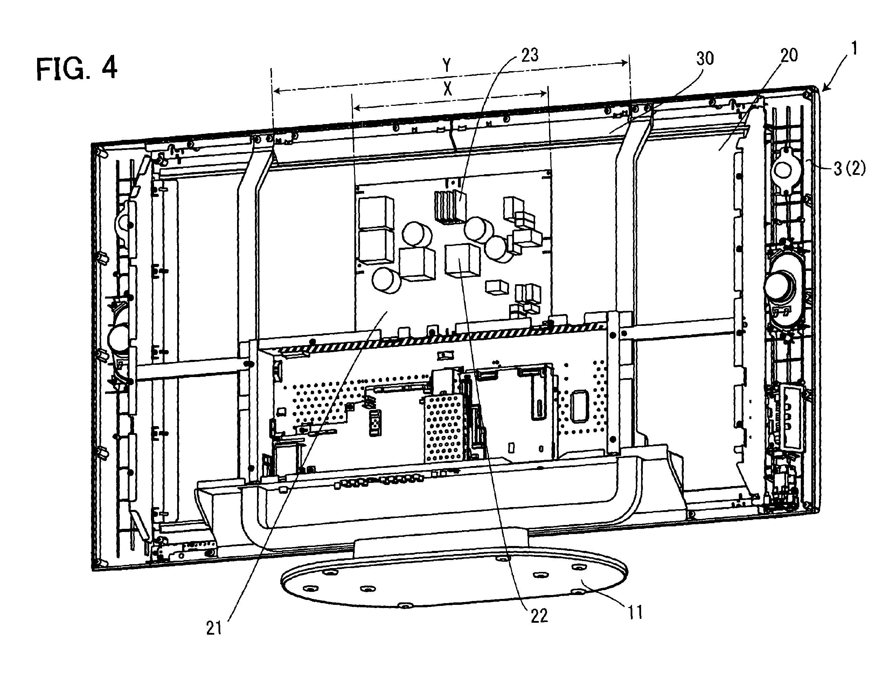

FIG. 3 is a sectional view of the display device viewed from one side and FIG. 4 is a perspective view of the display device rid of the back cabinet viewed from the back. With reference to these figures, the inner structure of the display device 1 will be explained below.

Reference numeral 20 is the aforementioned display panel which displays images and a power supply substrate 21 making up a circuit for operating the display panel 20 is attached to the back of the display panel 20. This power supply substrate 21 is provided with a heating part 22 such as a transformer which generates high-temperature heat when the display device 1 is in operation and a heat radiation member 23 for radiating heat of this heating part 22. Furthermore, the display device 1 is made up of a plurality of components such as a speaker which outputs sound inside the enclosure 2, a control substrate which controls the entire display device 1 and a shielding member, but these components are not particularly related to explanations of the contents of the present invention, and therefore detailed explanations thereof will be omitted in this embodiment. Note that the material of the heat radiation member 23 is aluminum which has high heat conductivity whereby heat of the heating part 22 is transmitted to the heat radiation member 23 through the power supply substrate 21, making it possible to effectively cool heat by means of natural convection, which will be described later.

The aforementioned exhaust holes 12 and air intake holes 10 are formed in the top surface and bottom surface of the back cabinet 4 as shown in FIG. 2 and FIG. 3 in such a way as to penetrate those surfaces and when the air inside the enclosure 2 is heated and the temperature increases as the heating part 22 mounted on the power supply substrate 21 generates heat, the heated air is exhausted through the exhaust holes 12 of the top surface of the back cabinet 4 and outside air is taken in through the air intake holes 10 formed in the bottom surface of the back cabinet 4 as the air from the exhaust holes 12 is exhausted. That is, the air heated in the enclosure 2 moves upward by means of natural convection and is thereby automatically exhausted through the exhaust holes 12 formed in the top surface of the back cabinet 4 and following this, outside air flows into the enclosure 2 through the air intake holes 10 and the introduced air pushes the air heated in the enclosure 2 further upward. Thus, without providing any air blowing fan for forcibly discharging air as in the conventional art, it is possible to smoothly exhaust the air heated in the enclosure 2, eliminate the necessity to provide an air blowing fan separately and reduce the number of parts and thereby suppress increases in the product cost.

Reference numeral 30 denotes a shielding plate attached in the upper part inside the enclosure 2. This shielding plate 30 is mounted above the power supply substrate 21, and as shown in FIG. 4, it is longer than the width of the power supply substrate 21 (width X of power supply substrate ≤ length Y of shielding plate) and when the air heated in the enclosure 2 due to heat generated from the heating part 22 mounted on the power supply substrate 21 moves upward, the shielding plate 30 prevents the high-temperature air from the power supply substrate 21 from directly contacting the upper part inside the enclosure 2, and can thereby prevent the enclosure 2 from being thermally deformed, and moreover the shielding plate 30 is provided in the upper part inside the enclosure 2 so that the ascending hot air in the enclosure 2 is not accumulated in a space S in the upper part of the enclosure 2 and the ascending air is guided along the surface of the shielding plate 30 and exhausted through the exhaust holes 12.

Furthermore, the plurality of exhaust holes 12 are formed over a range longer than the length Y of the aforementioned shielding plate 30 as shown in FIG. 1. As a result, the relationship between the width X of the power supply substrate 21, the length Y of the shielding plate 30 and the width Z of the range in which the plurality of exhaust holes 12 located above the shielding plate 30 is X≤Y≤Z.

The plurality of exhaust holes 12 are of a relatively small diameter and formed in the back cabinet 4, which can prevent dust from entering the enclosure 2 as much as possible and even if dust enters the enclosure 2 through the exhaust holes 12, since the shielding plate 30 is located above the power supply substrate 21, it is possible to prevent dust from accumulating on the power supply substrate 21 mounted with the heating part.

The diameters of the air intake holes 10 and exhaust holes 12 are preferably 3 mm to 5 mm and more specifically 3.5 mm.

As shown above, according to an example of the present invention, when the display panel 20 which displays images is in operation, it is possible to intake/exhaust the air heated to a high temperature by the power supply substrate 21 or the like mounted with the heating part inside the enclosure 2 through the plurality of exhaust holes 12 and air intake holes 10 formed in the slopes 4a, 4b of the top surface and bottom surface of the back cabinet 4 by means of natural convection without using any air blowing fan and thereby reliably exhaust and cool the air heated to a high temperature inside the enclosure 2. Moreover, this eliminates the necessity for any air blowing fan or wiring for supplying power to this air blowing fan, thereby reduce the number of parts, improve the manufacturing efficiency, suppress manufacturing cost, and also doing without the air blowing fan can avoid grating noise caused by operation of this air blowing fan.

Furthermore, since the shielding plate 30 is provided in the upper part in the enclosure 2, when the air heated to a high temperature inside the enclosure 2 moves upward by means of natural convection and part of the ascending air contacts the shielding plate 30, this air moves along the surface of the shielding plate 30, is discharged out of the enclosure 2 through the exhaust holes 12 and even if, for example, there are gaps or the like above the enclosure 2, it is possible to prevent the ascending hot air from flowing into these gaps and prevent heat from being confined therein. Therefore, it is possible to prevent the resin enclosure 2 from being deformed by heat or even if various parts liable to deteriorate or malfunction are provided in the upper part inside the enclosure 2, it is possible to eliminate adverse influences on such parts. Moreover, avoiding the use of any air blowing fan eliminates noise which would be caused by the rotation of the air blowing fan and eliminates the necessity for electrical connections or wiring to the air blowing fan, thus making it possible to reduce hours of assembly work, reduce the number of parts and thereby reduce factors of malfunction as well.

The heat radiation structure according to the present invention allows the high temperature air inside the enclosure 2 to be discharged out of the enclosure 2 and also allows outside air to be taken in, but it is not limited to discharging only heat generated from the heating part 22 mounted on the power supply substrate 21 out of the enclosure 2 and the present invention also includes discharging of heat generated from other components housed in the enclosure 2 and, for example, heat may also be generated from the display panel 20 and control substrate, which may cause an increase of the temperature inside the enclosure 2 and according to the structure of the present invention, it is also possible to discharge the air heated to a high temperature by such heat.

The display device having the heat radiation structure of the present invention is not limited to the display device shown in the embodiment, but also applicable to a hybrid electronic machine which incorporates, for example, a recording/reproducing unit which allows recording/reproducing of a disk type storage medium, hard disk unit or unit which allows reading/writing or both reading and writing of a plurality of storage media in the enclosure of a display device.

The effects of the present invention are as follows.

According to the display device of aspect 1, the display device with a display panel for displaying images accommodated in an enclosure, comprises a heating part which is heated inside the enclosure during operation of the display panel, a plurality of exhaust holes for discharging air heated to a high temperature inside the enclosure formed in the top surface of the enclosure and a plurality of air intake holes for taking in outside air formed in the bottom surface of the enclosure, and can thereby automatically take in/exhaust and cool the air inside the cabinet by means of natural convection and reliably suppress temperature increases of the display device without forcibly exhausting the air using an air blowing fan as in the conventional art. Therefore, it is possible to make the display device a low-cost product compared to the conventional product using an air blowing fan. The "low-cost product" here refers to not only a product which does not use expensive parts such as an air blowing fan but also a product which reduces hours of work of assembling the display device, the number of working steps and the number of workers.

According to the display device of aspect 2, the display device provided with a display panel for displaying images fitted in a front cabinet and a back cabinet combined with the front cabinet in an integrated manner comprises a heating part which generates high-temperature heat during operation of the display panel provided inside an enclosure made up of the front cabinet and back cabinet, a plurality of exhaust holes for exhausting air heated to a high temperature inside the enclosure formed in a top surface of the back cabinet and a plurality of air intake holes through which outside air is taken in formed in a bottom surface of the back cabinet, and can thereby automatically take in/exhaust and cool the air inside the cabinet by means of natural convection, reliably suppress temperature increases of the display device and also realize cost reduction because there is no need for using an air blowing fan as in the case of the conventional art.

According to the display device of aspect 3, a shielding plate for guiding the air heated to a high temperature to the exhaust holes is provided in an upper part inside the enclosure, and therefore it is possible to guide the air ascending by means of natural convection to the exhaust holes, smoothly discharge it out of the enclosure, and therefore even when various parts liable to deterioration or malfunction due to influences of heat are provided inside the enclosure, it is possible to eliminate the adverse influences on those parts, and furthermore avoiding the use of an air blowing fan eliminates noise produced during operation of the air blowing fan and eliminates the necessity for electrical connections or wiring to the air blowing fan, and can thereby reduce hours of assembly work.

According to the display device of aspect 4, the heating part is mounted on a power supply substrate to operate the display panel and the power supply substrate is provided with a heat radiation member for radiating heat of the heating part, and therefore heat from the power supply substrate provided with the heating part generating a relatively large amount of heat inside the enclosure is radiated out inside the enclosure through the heat radiation member, and it is possible to automatically discharge high-temperature air due to this heat to the outside through the plurality of exhaust holes and air intake holes without using any additional forcible member such as an air blowing fan.

According to the display device of aspect 5, the power supply substrate is disposed on the back side of the display panel between the plurality of air intake holes for taking in outside air and the plurality of exhaust holes for discharging air heated to a high temperature inside the enclosure, both holes being provided in the enclosure, and therefore it is possible to efficiently cool the interior of the enclosure by means of natural convection.

## Claims

1. A display device with a display panel for displaying images accommodated in an enclosure, comprising:
a heating part which is heated inside the enclosure during operation of the display panel;
a plurality of exhaust holes for discharging air heated to a high temperature inside the enclosure formed in the top surface of the enclosure; and
a plurality of air intake holes for taking in outside air formed in the bottom surface of the enclosure.

2. A display device provided with a display panel for displaying images fitted in a front cabinet and a back cabinet combined with the front cabinet in an integrated manner, comprising:
a heating part which generates high-temperature heat during operation of the display panel provided inside an enclosure made up of the front cabinet and back cabinet;
a plurality of exhaust holes for exhausting air heated to a high temperature inside the enclosure formed in a top surface of the back cabinet; and
a plurality of air intake holes through which outside air is taken in formed in a bottom surface of the back cabinet.

3. The display device according to claim 1 or 2, further comprising a shielding plate provided in an upper part inside the enclosure for guiding the air heated to a high temperature to the exhaust holes.

4. The display device according to any one of claims 1 to 3, wherein the heating part is mounted on a power supply substrate to operate the display panel, and
the power supply substrate is provided with a heat radiation member for radiating heat of the heating part.

5. The display device according to claim 4, wherein the power supply substrate is disposed on a back side of the display panel between the plurality of air intake holes for taking in outside air and the plurality of exhaust holes for discharging air heated to a high temperature inside the enclosure, both holes being provided in the enclosure.
